# EUROPEAN PATENT APPLICATION

(11) **EP 4 557 288 A1**
(43) Date of publication of application: **21.05.2025**
(21) Application number: 24211408.0
(22) Date of filing: 07.11.2024
(51) Int. Cl.: G11C 7/10, G11C 16/04, G11C 16/24, G11C 16/26, G11C 7/06

(54) **MEMORY DEVICE AND OPERATING METHOD OF THE SAME**

(30) Priority: 15.11.2023 KR 20230158623
(71) Applicant: Samsung Electronics Co., Ltd., Suwon-si, Gyeonggi-do 16677 (KR)
(72) Inventor: BANG, Jinbae, 16677 Suwon-si, Gyeonggi-do (KR); SONG, Kiwhan, 16677 Suwon-si, Gyeonggi-do (KR)
(74) Representative: Kuhnen & Wacker Patent- und Rechtsanwaltsbüro PartG mbB

(57) **Abstract**

A memory device (10) includes a memory cell array (100) including a plurality of memory cells, and a page buffer circuit (210) including a plurality of page buffers (PB) respectively coupled to the plurality of memory cells through a plurality of bit line. Each page buffer of the plurality of page buffers (PB) includes a first transistor coupling a corresponding bit line of the plurality of bit lines to a first node, based on a first control signal, a second transistor coupling the first node to a sensing node, a sensing latch configured to sense data stored in a corresponding memory cell, based on a first voltage level of the sensing node, a forcing latch configured to store forcing data, a first discharge transistor including a first gate terminal configured to receive the forcing data, and a second discharge transistor including a second gate terminal configured to receive a discharge control signal.

## Description

### BACKGROUND

### 1. Field

The present disclosure relates generally to a memory device, and more particularly, to a memory device including a page buffer circuit and an operating method of the same.

### 2. Description of Related Art

Recently, there may be an increased demand for higher capacity and/or higher integration of memory devices as the functions of information and/or communication devices may have diversified. A memory device may include a page buffer circuit for storing data in and/or outputting data from memory cells. For example, the page buffer circuit may include a plurality of page buffers arranged to correspond to a plurality of bit lines, and each page buffer may have semiconductor elements such as, but not limited to, transistors.

However, the length of the bit lines in the memory devices may decrease (e.g., become shorter) as the integration level of the memory devices increases. As a result, a phenomenon in which the voltage level of the bit line may increase excessively due to coupling formed by the voltage applied to the word line.

Thus, there exists a need for further improvements in memory devices, as the need for higher integration may be constrained by the length of the bit lines in the memory devices. Improvements are presented herein. These improvements may also be applicable to other memory storage technologies.

### SUMMARY

One or more example embodiments of the present disclosure provide a memory device that maintains the voltage level of a bit line constant even when coupling occurs due to a program voltage applied to a word line, and a method of operating the same.

According to an aspect of the present disclosure, a memory device includes a memory cell array including a plurality of memory cells, and a page buffer circuit including a plurality of page buffers respectively coupled to the plurality of memory cells through a plurality of bit lines. Each page buffer of the plurality of page buffers includes a first transistor coupling a corresponding bit line of the plurality of bit lines to a first node, based on a first control signal, a second transistor coupling the first node to a sensing node, a sensing latch configured to sense data stored in a corresponding memory cell, based on a first voltage level of the sensing node, a forcing latch configured to store forcing data, a first discharge transistor including a first gate terminal configured to receive the forcing data, a first end of the first discharge transistor being coupled to a discharge node, and a second end of the first discharge transistor being coupled to a second node, and a second discharge transistor including a second gate terminal configured to receive a discharge control signal, a third end of the second discharge transistor being coupled to the second node, and a fourth end of the second discharge transistor being coupled to the first node.

According to an aspect of the present disclosure, an operating method of a memory device includes turning on a first transistor coupling a bit line to a first node, in a bit line setup period, turning on a second transistor that precharges the first node, in the bit line setup period, transferring data stored in a forcing latch to a sensing latch, in a forcing dump period following the bit line setup period, turning on the first transistor, in a bit line forcing period following the forcing dump period and in a forcing sustain period following the bit line forcing period, turning on the second transistor in the bit line forcing period, turning off the second transistor in the forcing sustain period, and turning on, in the forcing sustain period, a third transistor including a first end coupled to a discharge node and a second end coupled to the first node.

According to an aspect of the present disclosure, a memory device includes a memory cell array including a plurality of memory cells, and a page buffer circuit including a plurality of page buffers respectively coupled to the plurality of memory cells through a plurality of bit lines. Each page buffer of the plurality of page buffers includes a first transistor coupling a corresponding bit line of the plurality of bit lines to a first node, based on a first control signal, a second transistor coupling the first node to a sensing node, a sensing latch configured to sense data stored in a corresponding memory cell, based on a first voltage level of the sensing node, a forcing latch configured to store forcing data, a first discharge transistor including a first gate terminal configured to receive the forcing data, a first end of the first discharge transistor being coupled to a discharge node, and a second end of the first discharge transistor being coupled to a second node, and a second discharge transistor including a second gate terminal configured to receive a discharge control signal, a third end of the second discharge transistor being coupled to the second node, and a fourth end of the second discharge transistor being coupled to the first node, and a precharge circuit configured to precharge the first node, and including a third transistor including a third gate terminal configured to receive a second control signal, a fifth end of the third transistor being coupled to the first node, and a fourth transistor including a fourth gate terminal coupled to an output node of the sensing latch, a seventh end of the fourth transistor being coupled to a power supply voltage, and an eighth end of the fourth transistor being coupled to a sixth end of the third transistor.

Additional aspects may be set forth in part in the description which follows and, in part, may be apparent from the description, and/or may be learned by practice of the presented embodiments.

### BRIEF DESCRIPTION OF DRAWINGS

The above and other aspects, features, and advantages of certain embodiments of the present disclosure may be more apparent from the following description taken in conjunction with the accompanying drawings in which:
FIG. 1 is a block diagram showing a memory device, according to an embodiment;
FIG. 2 schematically shows a structure of the memory device of FIG. 1, according to an embodiment;
FIG. 3 shows an example of the memory cell array of FIG. 1, according to an embodiment;
FIG. 4 is a perspective view showing the memory block of FIG. 3, according to an embodiment;
FIG. 5 shows an example of the connection between the memory cell array and the page buffer circuit, according to an embodiment;
FIG. 6 shows a page buffer, according to an embodiment;
FIG. 7 is a diagram illustrating a memory cell array, according to an embodiment;
FIG. 8 shows a portion of a page buffer, according to an embodiment;
FIG. 9 is a timing diagram illustrating an operating method of a memory device, according to a comparative example;
FIG. 10 is a timing diagram illustrating an operating method of a memory device, according to an embodiment;
FIG. 11 is a diagram showing a portion of a page buffer, according to an embodiment;
FIG. 12 is a timing diagram illustrating an operating method of a memory device, according to an embodiment;
FIG. 13 is a block diagram showing an example of applying a memory system to a solid-state drive (SSD) system, according to an embodiment; and
FIG. 14 is a diagram illustrating a memory device, according to an embodiment.

### DETAILED DESCRIPTION OF EMBODIMENTS

The following description with reference to the accompanying drawings is provided to assist in a comprehensive understanding of embodiments of the present disclosure defined by the claims and their equivalents. Various specific details are included to assist in understanding, but these details are considered to be exemplary only. In addition, descriptions of well-known functions and structures are omitted for clarity and conciseness.

With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wired), wirelessly, or via a third element.

It is to be understood that when an element or layer is referred to as being "over," "above," "on," "below," "under," "beneath," "connected to" or "coupled to" another element or layer, it may be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

The terms "upper," "middle", "lower", and the like may be replaced with terms, such as "first," "second," third" to be used to describe relative positions of elements. The terms "first," "second," third" may be used to describe various elements but the elements are not limited by the terms and a "first element" may be referred to as a "second element". Alternatively or additionally, the terms "first", "second", "third", and the like may be used to distinguish components from each other and do not limit the present disclosure. For example, the terms "first", "second", "third", and the like may not necessarily involve an order or a numerical meaning of any form.

As used herein, when an element or layer is referred to as "covering" another element or layer, the element or layer may cover at least a portion of the other element or layer, where the portion may include a fraction of the other element or may include an entirety of the other element. Similarly, when an element or layer is referred to as "penetrating" another element or layer, the element or layer may penetrate at least a portion of the other element or layer, where the portion may include a fraction of the other element or may include an entire dimension (e.g., length, width, depth) of the other element.

Reference throughout the present disclosure to "one embodiment," "an embodiment," "an example embodiment," or similar language may indicate that a particular feature, structure, or characteristic described in connection with the indicated embodiment is included in at least one embodiment of the present solution. Thus, the phrases "in one embodiment", "in an embodiment," "in an example embodiment," and similar language throughout this disclosure may, but do not necessarily, all refer to the same embodiment. The embodiments described herein are example embodiments, and thus, the disclosure is not limited thereto and may be realized in various other forms.

It is to be understood that the specific order or hierarchy of blocks in the processes/flowcharts disclosed are an illustration of exemplary approaches. Based upon design preferences, it is understood that the specific order or hierarchy of blocks in the processes/flowcharts may be rearranged. Further, some blocks may be combined or omitted. The accompanying claims present elements of the various blocks in a sample order, and are not meant to be limited to the specific order or hierarchy presented.

As used herein, each of the terms "SiO", "SiN", and the like may refer to a material made of elements included in each of the terms and is not a chemical formula representing a stoichiometric relationship.

Hereinafter, various embodiments of the present disclosure are described with reference to the accompanying drawings.

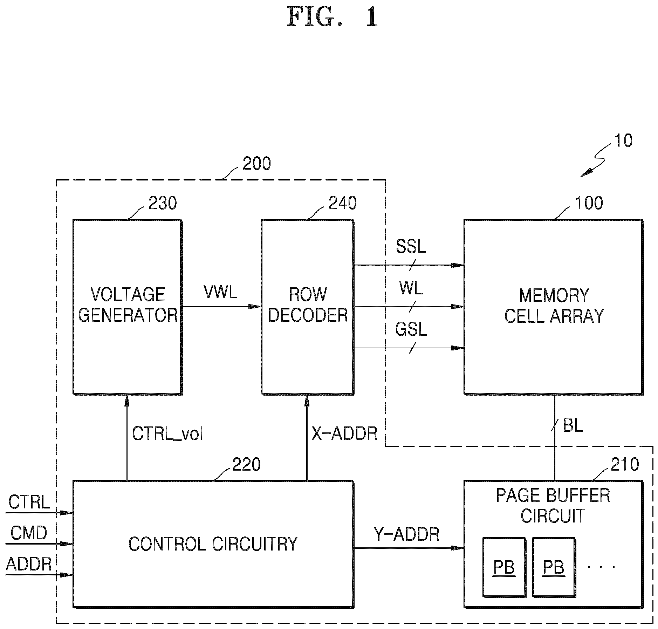

FIG. 1 is a block diagram showing a memory device 10, according to an embodiment.

Referring to FIG. 1, the memory device 10 may include a memory cell array 100 and a peripheral circuit 200. The peripheral circuit 200 may include a page buffer circuit 210, a control circuit 220, a voltage generator 230, and a row decoder 240. In an embodiment, the peripheral circuit 200 may further include a data input/output (I/O) circuit or an I/O interface. Alternatively or additionally, the peripheral circuit 200 may further include column logic, a pre-decoder, a temperature sensor, a command decoder, an address decoder, or the like.

The memory cell array 100 may be connected to the page buffer circuit 210 through bit lines BL and may be connected to the row decoder 240 through word lines WL, string select lines SSL, and ground select lines GSL. The memory cell array 100 may be and/or may include a plurality of memory cells. For example, the plurality of memory cells may be and/or may include flash memory cells. Hereinafter, embodiments of the present disclosure may be described using an example in which the plurality of memory cells are NAND flash memory cells. However, the present disclosure is not limited thereto, and in some embodiments, the plurality of memory cells may be and/or may include resistive memory cells, such as, but not limited to, resistive random-access memory (ReRAM), phase change random-access memory (PRAM), magnetic random-access memory (MRAM), or the like.

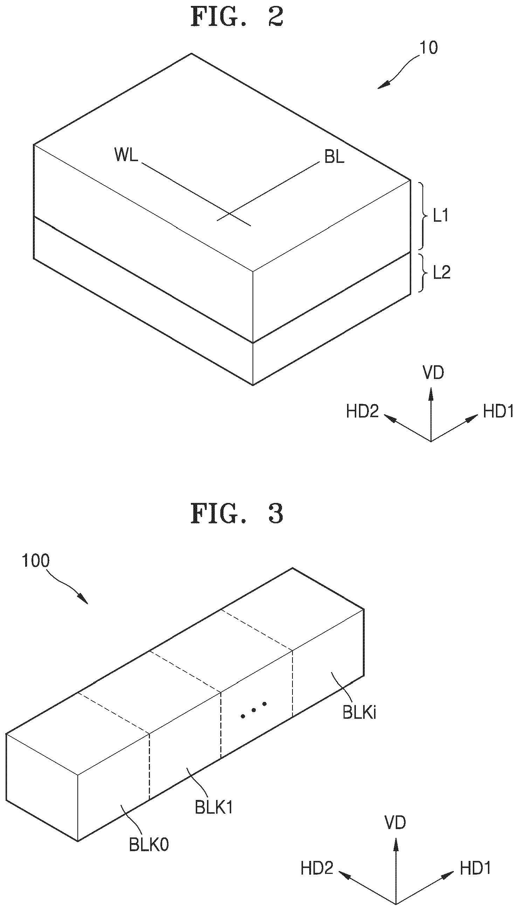

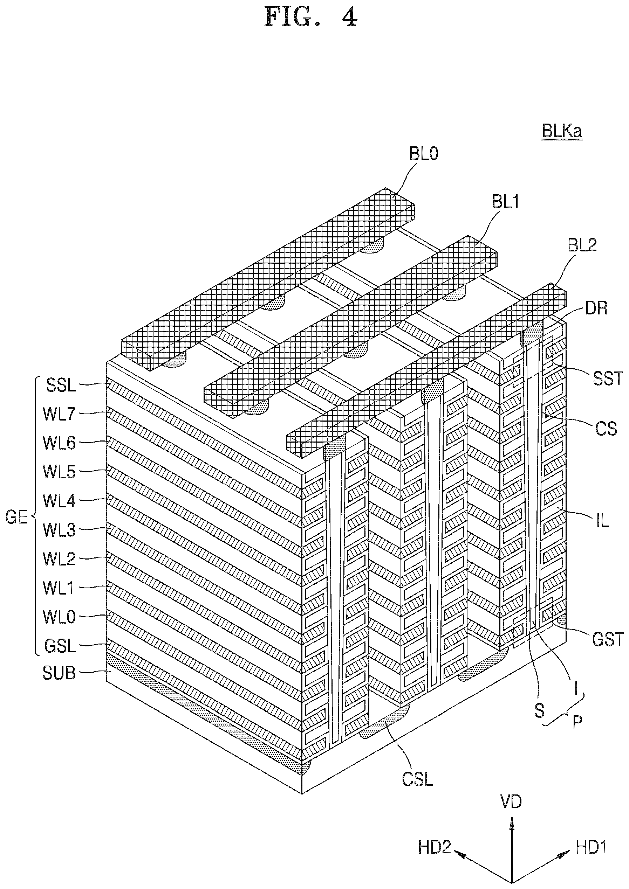

In one embodiment, the memory cell array 100 may be and/or may include a three-dimensional (3D) memory cell array, the 3D memory cell array may be and/or may include a plurality of NAND strings, each NAND string may include memory cells each connected to word lines stacked vertically on a substrate, and these are described with reference to FIGS. 3 and 4.

Configurations in which the 3D memory array is composed of a plurality of levels, with word lines and/or bit lines that are shared between the levels, suitable for the 3D memory array are disclosed in U.S. Patent No. 7,679,133, U.S. Patent No. 8,553,466, U.S. Patent No. 8,654,587, U.S. Patent No. 8,559,235, and U.S. Patent No. 9,536,970. However, the present disclosure is not limited thereto, and in some embodiments, the memory cell array 100 may be and/or may include a two-dimensional (2D) memory cell array. The 2D memory cell array may be and/or may include a plurality of NAND strings arranged along row and column directions.

Based on commands CMD, addresses ADDR, and control signals CTRL, the control circuit 220 may output various control signals for programming data in the memory cell array 100, reading data from the memory cell array 100, and/or erasing data stored in the memory cell array 100. For example, the control circuit 220 may output a voltage control signal CTRL_vol, a row address X-ADDR, a column address Y-ADDR, or the like. Accordingly, the control circuit 220 may generally control various operations within the memory device 10.

The voltage generator 230 may generate various types of voltages to perform program, read, and/or erase operations on the memory cell array 100 based on the voltage control signal CTRL_vol. That is, the voltage generator 230 may generate a word line voltage VWL, such as, but not limited to, a program voltage, a read voltage, a pass voltage, an erase verification voltage, a program verification voltage, or the like. Alternatively or additionally, the voltage generator 230 may further generate a string selection line voltage and a ground selection line voltage based on the voltage control signal CTRL_vol.

In response to the row address X-ADDR, the row decoder 240 may select one of a plurality of memory blocks, select one of the word lines WL of the selected memory block, and select one of a plurality of string selection lines SSL. The page buffer circuit 210 may select some of the bit lines BL in response to the column address Y-ADDR. That is, the page buffer circuit 210 may operate as a write driver and/or a sense amplifier depending on the operation mode.

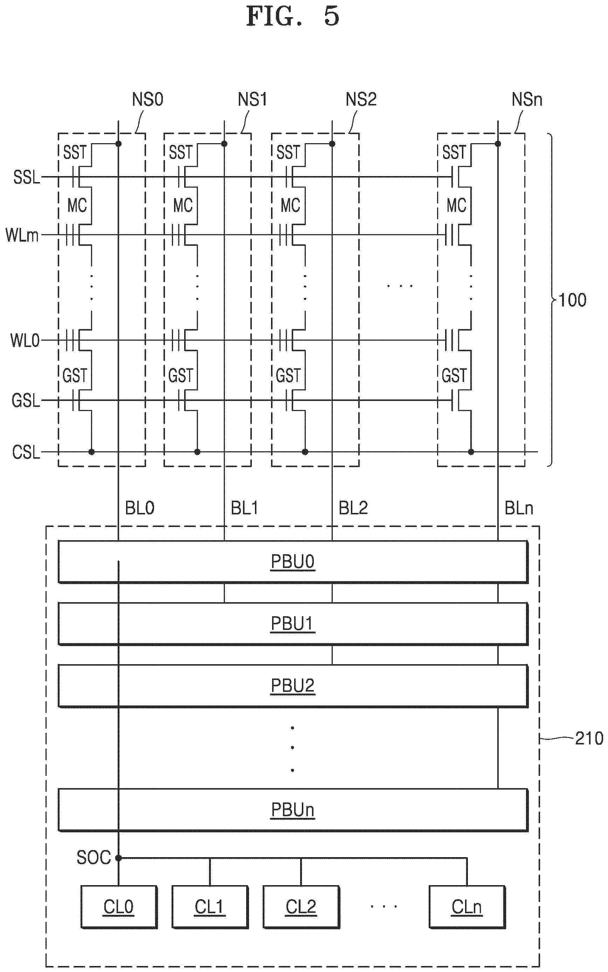

The page buffer circuit 210 may include a plurality of page buffers PB that may each be connected to a plurality of bit lines BL. In this embodiment, a plurality of page buffer units (e.g., a first page buffer unit PBU0, a second page buffer unit PBU1, a third page buffer unit PBU2, to an (n+1)-th page buffer unit PBUn in FIG. 5, where n is a positive integer greater than one (1), hereinafter generally referred to as "PBU") included in each page buffer of the plurality of page buffers PB and the cache latches (e.g., a first cache latch CL0, a second cache latch CL1, a third cache latch CL2, to an (n+1)-th cache latch CLn in FIG. 5) included in each page buffer of the plurality of page buffers PB may be spaced apart from each other and may have a separate structure. Each page buffer unit of the plurality of page buffer units PBU may be connected to one bit line of the plurality of bit lines BL.

Each page buffer of the plurality of page buffers may precharge a bit line in the next program loop based on the program verification result of the previous program loop and forcing data. That is, the page buffer may precharge the bit line connected to the memory cell that is the target of the program to the program allowable voltage, and may precharge a bit line connected to a memory cell that is not the target of programming to a program prohibition voltage. The program allowable voltage may be a ground voltage, and the program inhibition voltage may be a positive power supply voltage (e.g., VDD). However, the present disclosure is not limited in this regard, and the program allowable voltage and the program inhibition voltage may be set to other voltage values. A bit line to which a program prohibition voltage is applied may be referred to as a program prohibition bit line, a bit line to which a program allowable voltage is applied may be referred to as a program allowable bit line, and a bit line to which a forcing voltage is applied may be referred to as a forcing bit line.

The page buffer circuit 210 may apply a program allowable voltage to a bit line connected to a slow memory cell among memory cells subject to programming through a bit line forcing operation, and may apply a forcing voltage to a bit line connected to a fast memory cell among the plurality of memory cells to be programmed. The level of the forcing voltage may be greater than the level of the program allowable voltage and lower (e.g., less) than the level of the program inhibition voltage.

The voltage level of the bit line may be transmitted to the channel of the NAND string. The greater the difference between the voltage level of the channel of the NAND string and the word line voltage level, the greater the threshold voltage of the memory cell may increase. That is, the lower the voltage level of the bit line, the greater the threshold voltage of the memory cell may increase.

Accordingly, the threshold voltage of the memory cell connected to the program allowable bit line may increase to a greater extent than the threshold voltage of the memory cell connected to the forcing bit line.

During a program operation, when the connection between the bit lines and the page buffer circuit is disconnected after the program allowable voltage, forcing voltage, or program inhibition voltage may be applied to a plurality of bit lines. For example, when the bit line is floating, a situation may occur in which the memory cell connected to the forcing bit line is not programmed.

That is, as the memory device 10 is integrated, the length of the bit line may become shorter and the capacitance of the bit line may decrease. Therefore, when a program voltage or the like is applied to the word line while the bit line is floating, the voltage level of the forcing bit line may excessively increase due to coupling between the bit line and the word line. Accordingly, as the voltage level of the forcing bit line rises to a voltage level near the program prohibition voltage, a situation may occur in which the memory cell connected to the forcing bit line is not programmed.

According to an embodiment, after the program allowable voltage, the forcing voltage, or the program prohibition voltage is applied to a plurality of bit lines, the voltage level of the forcing bit line may be maintained at the voltage level of the forcing voltage by discharging the forcing bit line to a constant level.

Accordingly, even if the capacitance of the bit line decreases as the memory device 10 is integrated, the accuracy of the program operation may be improved.

FIG. 2 schematically shows a structure of the memory device 10 of FIG. 1, according to an embodiment. Referring to FIG. 2, the memory device 10 may include a first semiconductor layer L1 and a second semiconductor layer L2. The first semiconductor layer L1 may be stacked in a vertical direction VD with respect to the second semiconductor layer L2. That is, the second semiconductor layer L2 may be disposed below the first semiconductor layer L1 in the vertical direction VD, and accordingly, the second semiconductor layer L2 may be disposed close to a substrate.

In one embodiment, the memory cell array 100 of FIG. 1 may be formed in the first semiconductor layer L1, and the peripheral circuit 200 of FIG. 1 may be formed in the second semiconductor layer L2. Accordingly, the memory device 10 may have a structure in which the memory cell array 100 is disposed on an upper portion of the peripheral circuit 200, that is, a cell over periphery (COP) structure. The COP structure may effectively reduce the horizontal area and improve the integration of the memory device 10.

In one embodiment, the second semiconductor layer L2 may include the substrate, and the peripheral circuit 200 may be formed on the second semiconductor layer L2 by forming transistors and metal patterns for wiring the transistors on the substrate. After the peripheral circuit 200 is formed in the second semiconductor layer L2, the first semiconductor layer L1 including the memory cell array 100 may be formed, and metal patterns may be formed to electrically connect word lines WL and bit lines BL of the memory cell array 100 to the peripheral circuit 200 formed in the second semiconductor layer L2. For example, the plurality of bit lines BL may extend in a first horizontal direction HD1, and the plurality of word lines WL may extend in a second horizontal direction HD2.

With the development of semiconductor processes, as the number of memory cells arranged in the memory cell array 100 may increase, that is, as the number of stacked word lines WL may increase, the area of the memory cell array 100 may decrease, and thus the area of the peripheral circuit 200 may also decrease. According to an embodiment, in order to reduce the area occupied by the page buffer circuit 210, the page buffer circuit 210 may have a structure in which the page buffer unit PBU and the cache latch CL are separated, and the sensing nodes included in each page buffer unit PBU may be commonly connected to a combined sensing node.

FIG. 3 shows an example of the memory cell array 100 of FIG. 1 according to an embodiment. Referring to FIG. 3, the memory cell array 100 may include a plurality of memory blocks (e.g., a first memory block BLK0, a second memory block BLK1, to an (i+1)-th memory block BLKi, where i is a positive integer greater than one (1), hereinafter generally referred to as "BLK"). Each memory block of the plurality of memory blocks BLK may have a 3D structure (or vertical structure). That is, each memory block of the plurality of memory blocks BLK may include a plurality of NAND strings extended in the vertical direction VD. In such an embodiment, a plurality of NAND strings may be provided spaced apart by a specific distance in the first and second horizontal directions HD1 and HD2. The plurality of memory blocks BLK may be selected by a row decoder (e.g., the row decoder 240 in FIG. 1). For example, the row decoder 240 may select a memory block corresponding to a block address from among the plurality of memory blocks BLK.

FIG. 4 is a perspective view showing the memory block BLKa of FIG. 3, according to an embodiment.

Referring to FIG. 4, the memory block BLKa may be formed in a vertical direction with respect to a substrate SUB. The substrate SUB may be provided with a common source line CSL that may have a first conductivity type (e.g., p-type), may extend in the second horizontal direction HD2, and may be doped with impurities of the second conductivity type (e.g., n-type). On the area of the substrate SUB between two adjacent common source lines CSL, a plurality of insulating films IL extending in the second horizontal direction HD2 may be sequentially provided in the vertical direction VD. The plurality of insulating films IL may be spaced apart by a specific distance in the vertical direction VD. For example, the plurality of insulating films IL may include an insulating material, such as, but not limited to, silicon oxide (SiO), or the like.

On an area of the substrate SUB between two adjacent common source lines CSL, a plurality of pillars P may be provided, which may be sequentially disposed in a first horizontal direction HD 1 and may penetrate a plurality of insulating films IL in a vertical direction VD. For example, the plurality of pillars P may penetrate the plurality of insulating films IL to contact the substrate SUB. That is, the surface layer S of each pillar P may include a silicon (Si) material of the first type and may function as a channel area. An inner layer I of each pillar P may include an insulating material such as, but not limited to, silicon oxide (SiO), an air gap, or the like.

In the area between two adjacent common source lines CSL, the insulating films IL, the pillars P, and a charge storage layer CS along the exposed surfaces of substrate SUB may be provided The charge storage layer CS may include a gate insulating layer (may also be referred to as a tunneling insulating layer), a charge trap layer, and a blocking insulating layer. For example, the charge storage layer CS may have an oxide-nitride-oxide (ONO) structure. Alternatively or additionally, in the area between two adjacent common source lines CSL, a gate electrode GE, such as, but not limited to, ground select lines GSL, string select lines SSL, and word lines (e.g., a first word line WL0, a second word line WL1, a third word line WL2, a fourth word line WL3, a fifth word line WL4, a sixth word line WL5, a seventh word line WL6, an eighth word line WL7), may be provided on the exposed surface of the charge storage layer CS.

Drains or drain contacts DR may be respectively provided on the plurality of pillars P. For example, the drains or the drain contacts DR may include a silicon (Si) material doped with impurities having a second conductivity type. On the drains or drain contacts DR, bit lines (e.g., a first bit line BL1, a second bit line BL2, a third bit line BL3) may be provided, extending in the first horizontal direction HD1 and spaced apart by a specific distance in the second horizontal direction HD2.

FIG. 5 shows an example of the connection between the memory cell array 100 and the page buffer circuit 210, according to an embodiment

Referring to FIG. 5, the memory cell array 100 may include first to (n+1)-th NAND strings (e.g., a first NAND string NS0, a second NAND string NS1, a third NAND string NS2, an (n+1)-th NAND string NSn). Each NAND string of the first to (n+1)-th NAND strings NS0 to NSn may include a ground select transistor GST connected to a ground select line GSL, a plurality of memory cells MC respectively connected to a plurality of word lines (e.g., a first word line WL0 to an (m+1)-th word line WLm, where m is a positive integer greater than one (1)), and a string selection transistor SST connected to a string selection line SSL. The ground select transistor GST, the plurality of memory cells MC, and the string select transistor SST may be connected to each other in series.

The page buffer circuit 210 may include first to (n+1)-th page buffer units PBU0 to PBUn. The first page buffer unit PBU0 may be connected to the first NAND string NS0 through the first bit line BL0, and the (n+1)-th page buffer unit PBUn may be connected to the (n+1)-th NAND string NSn through the (n+1)-th bit line BLn. For example, n may be seven (7) (e.g., n = 7), and the page buffer circuit 210 may have a structure in which eight (8) page buffer units PBU0 to PBUn may be arranged in a row. As another example, the first to (n+1)-th page buffer units PBU0 to PBUn may be arranged in a row in the extension direction of the first to (n+1)-th bit lines BL0 to BLn.

The page buffer circuit 210 may further include first to (n+1)-th cache latches CL0 to CLn respectively corresponding to the first to (n+1)-th page buffer units PBU0 to PBUn. For example, n may be 7 (e.g., n = 7), and the page buffer circuit 210 may have a structure in which eight (8) cache latches CL0 to CLn are arranged in a row. For example, the first to (n+1)-th cache latches CL0 to CLn may be arranged in a row in the extension direction of the first to (n+1)-th bit lines BL0 to BLn.

Sensing nodes of each page buffer unit of the first to (n+1)-th page buffer units PBU0 to PBUn may be commonly connected to a combined sensing node SOC. Alternatively or additionally, the first to (n+1)-th cache latches CL0 to CLn may be commonly connected to the combined sensing node SOC. Accordingly, the first to (n+1)-th page buffer units PBU0 to PBUn may be connected to the first to (n+1)-th cache latches CL0 to CLn through the combined sensing node SOC.

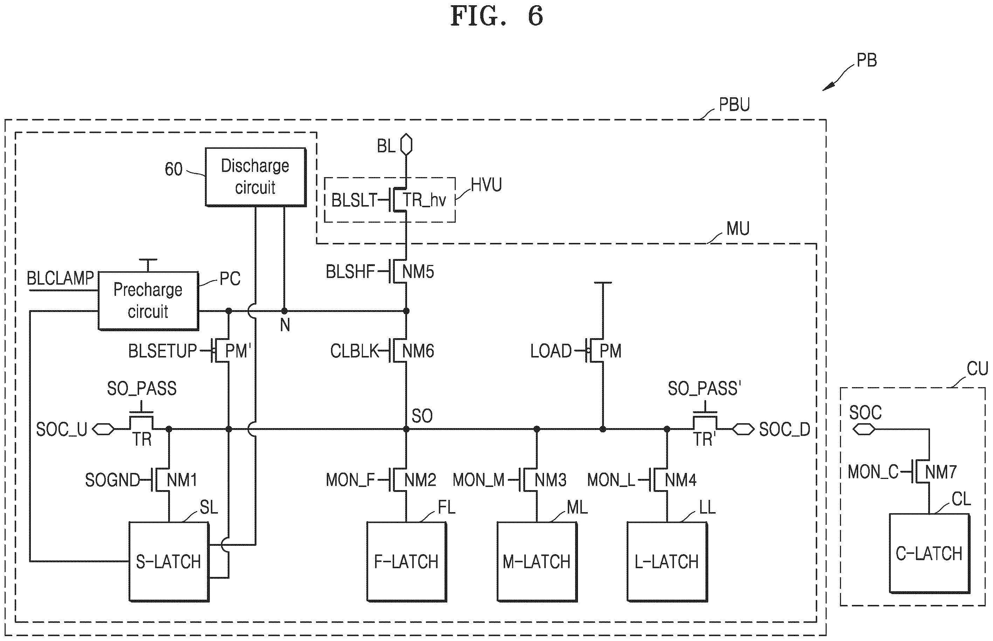

FIG. 6 shows a page buffer PB, according to an embodiment.

Referring to FIG. 6, the page buffer PB may correspond to an example of the page buffer PB of FIG. 1. The page buffer PB may include a page buffer unit PBU and a cache unit CU. The cache unit CU may include a cache latch (C-LATCH) CL, and the cache latch CL may be connected to the data I/O line, and as a result, the cache unit CU may be placed adjacent to the data I/O line. Accordingly, the page buffer unit PBU and cache unit CU may be placed spaced apart from each other, and the page buffer PB may have a separate structure of page buffer unit PBU and cache unit CU.

The page buffer unit PBU may include a main unit MU. The main unit MU may include main transistors in the page buffer PB. The page buffer unit PBU may further include a bit line select transistor TR_hv connected to the bit line BL and driven by the bit line select signal BLSLT. The bit line select transistor TR_hv may be implemented as a high voltage transistor. Accordingly, the bit line selection transistor TR_hv may be placed in a well area different from the main unit MU, that is, a high voltage unit HVU.

The main unit MU may include a sensing latch (S-LATCH) SL, a forcing latch (F-LATCH) FL, an upper bit latch (M-LATCH) ML, and a lower bit latch (L-LATCH) LL. In an embodiment, a sensing latch SL, a forcing latch FL, an upper bit latch ML, or a lower bit latch LL may be referred to as a "main latch". The main unit MU may further include a precharge circuit PC capable of controlling a precharge operation for the bit line BL or the sensing node SO based on a bit line clamping control signal BLCLAMP and may further include a transistor PM' driven by a bit line setup signal BLSETUP. The transistor PM' may precharge the sensing node SO to the precharge level in the precharge period.

The sensing latch SL may store data stored in a memory cell or a sensing result of the threshold voltage of the memory cell during a read or program verify operation. Alternatively or additionally, the sensing latch SL may be used to apply a program allowable voltage or a program inhibition voltage to the bit line BL during a program operation. The forcing latch FL may be used to potentially improve threshold voltage distribution during program operation. That is, the forcing latch (FL) may store forcing data. The forcing data may be initially set to '1' (e.g., a logic high) and then reversed to '0' (e.g., a logic low) when the threshold voltage of the memory cell enters the forcing area in which the threshold voltage of the memory cell is lower than the target area. By using forcing data, the bit line voltage may be controlled and the program threshold voltage distribution may be formed more narrowly during program execution. That is, by using forcing data, the bit line voltage may be controlled to be the program allowable voltage or forcing voltage.

The upper bit latch ML, the lower bit latch LL, and the cache latch CL may be used to store externally input data during program operation and may be referred to as a "data latch". When programming three (3) bits of data in one memory cell, the three (3) bits of data may be respectively stored in the upper bit latch ML, the lower bit latch LL, and the cache latch CL. Until the program of the memory cell is completed, the upper bit latch ML, the lower bit latch LL, and the cache latch CL may retain the stored data. Alternatively or additionally, the cache latch CL may receive data read from the memory cell during a read operation from the sensing latch SL and output the data to the outside through the data I/O line.

Alternatively or additionally, the main unit MU may further include first to fourth transistors (e.g., a first transistor NM1, a second transistor NM2, a third transistor NM3, and a fourth transistor NM4). The first transistor NM1 may be connected between the sensing node SO and the sensing latch SL, and may be driven by a ground control signal SOGND. The second transistor NM2 may be connected between the sensing node SO and the forcing latch FL, and may be driven by a forcing monitoring signal MON_F. The third transistor NM3 may be connected between the sensing node SO and the upper bit latch ML, and may be driven by an upper bit monitoring signal MON_M. The fourth transistor NM4 may be connected between the sensing node SO and the lower bit latch LL, and may be driven by a lower bit monitoring signal MON_L.

Alternatively or additionally, the main unit MU may further include a fifth transistor NM5 and a sixth transistor NM6 connected in series between the bit line selection transistor TV_hv and the sensing node SO. The fifth transistor NM5 may be driven by a bit line shut-off signal BLSHF, and the sixth transistor NM6 may be driven by a bit line connection control signal CLBLK. Alternatively or additionally, the main unit MU may further include a precharge transistor PM. The precharge transistor PM may be connected to the sensing node SO, driven by the load signal LOAD, and may precharge the sensing node SO to the precharge level in the precharge period.

The main unit MU may further include a pair of pass transistors (e.g., a first pass transistor TR and a second pass transistor TR') connected to the sensing node SO. The first and second pass transistors TR and TR' may also be referred to as first and second sensing node connection transistors. The first and second pass transistors TR and TR' may be driven depending on the sensing node pass control signal SO_PASS. The first pass transistor TR may be connected between a first terminal SOC_U and the sensing node SO, and the second pass transistor TR' may be connected between the sensing node SO and a second terminal SOC_D. Although FIG. 6 shows that the same sensing node pass control signal SO_PASS is applied to the first and second pass transistors TR and TR', the present disclosure is not limited thereto. That is, different sensing node pass control signals may be applied to the first and second pass transistors TR and TR'.

The page buffer PB may verify whether the program of a selected memory cell from among the plurality of memory cells included in the NAND string connected to the bit line BL has been completed during a program operation. That is, the page buffer PB may store data sensed through the bit line BL in the sensing latch SL during a program verification operation. The upper bit latch ML and the lower bit latch LL where the target data is stored may be set depending on the sensed data stored in the sensing latch SL. For example, when the sensed data indicates that the program has completed, the upper bit latch ML and lower bit latch LL may be switched to program inhibit settings for the selected memory cell in the subsequent program loop. The cache latch CL may temporarily store input data provided from the outside. During program operation, target data stored in the cache latch CL may be stored in the upper bit latch ML and the lower bit latch LL.

According to an embodiment, the main unit MU may include a discharge circuit 60.

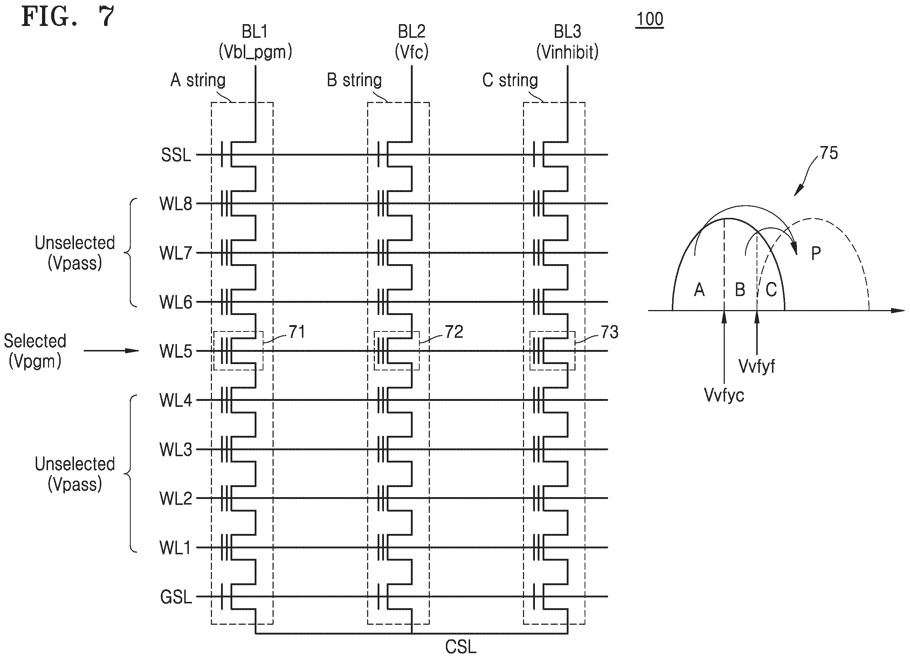

After the bit line BL is precharged to the forcing voltage, the bit line shut-off signal BLSHF may maintain the turn-on state. The discharge circuit 60 may discharge node N to the level of the discharge node (e.g., DISCH_n in FIG. 7). Because the discharge circuit 60 maintains the node N at the level of the discharge node (DISCH_n in FIG. 7), the voltage level of the bit line BL may be maintained at the forcing voltage even when the program voltage is applied to the word line.

FIG. 7 is a diagram illustrating a memory cell array 100, according to an embodiment.

Referring to FIG. 7, the memory cell array 100 may include A, B, and C NAND strings connected to first to eighth word lines WL1 to WL8, a string select line SSL, a ground select line GSL, a common source line CSL, and first to third bit lines BL1 to BL3. Each of the A, B, and C NAND strings may include a plurality of memory cells. For example, the A NAND string may include a first memory cell 71, the B NAND string may include a second memory cell 72, and the C NAND string may include a third memory cell 73.

In an embodiment, as shown in FIG. 7, the fifth word line WL5 may be a selected word line, and the first to fourth and sixth to eighth word lines WL1 to WL4 and WL6 to WL8 may be unselected word lines. The target program state of memory cells connected to the fifth word line WL5 may be P.

The threshold voltage of the first memory cell 71 included in the A NAND string may be included in a first area A of graph 75, the threshold voltage of the second memory cell 72 included in the B NAND string may be included in a second area B of the graph 75, and the threshold voltage of the third memory cell 73 included in the C NAND string may be included in a third area C of the graph 75. The first area A may refer to an area with a threshold voltage lower than a coarse verification voltage Vvfyc, the second area B may refer to an area having a threshold voltage between the coarse verification voltage Vvfyc and a fine verification voltage Vvfyf, and the third area C may refer to an area having a threshold voltage higher than the fine verification voltage Vvfyf. The second area B may be referred to as the forcing area. The first area A may be referred to as a program target area other than the forcing area. The third area C may be referred to as a program prohibition area. Forcing data that distinguishes first area A and second area B may be stored in the forcing latch FL.

Because the third area C is included in the target program state P, the third memory cell 73 may not be programmed in the next program loop. Because the first and second areas A and B are not included in the target program state P, the first and second memory cells 71 and 72 may be programmed in the next program loop.

That is, during a program operation, a bit line program allowable voltage Vbl_pgm may be applied to the first bit line BL1, a forcing voltage Vfc may be applied to the second bit line BL2, and a program inhibition voltage Vinhibit may be applied to the third bit line BL3. The bit line program allowable voltage Vbl_pgm may be a ground voltage, the program prohibition voltage Vinhibit may be a positive power supply voltage, and the forcing voltage Vfc may have a level between the program allowable voltage Vbl_pgm and the program inhibition voltage Vinhibit.

A program voltage Vpgm may be applied to the selected word line, and a pass voltage Vpass may be applied to the unselected word line. The first and second memory cells 71 and 72 may be programmed due to a voltage difference between the program voltage Vpgm and the channels of the first to third memory cells 71 to 73. Because the channel of C NAND string is floating due to the program prohibition voltage Vinhibit, the third memory cell 73 may not be substantially programmed. Because the program allowable voltage Vbl_pgm is lower than the forcing voltage Vfc, the threshold voltage of the first memory cell 71 may increase significantly than the threshold voltage of the second memory cell 72.

Therefore, when performing a program operation using forcing data, the distribution width of the target program state P may be narrowed.

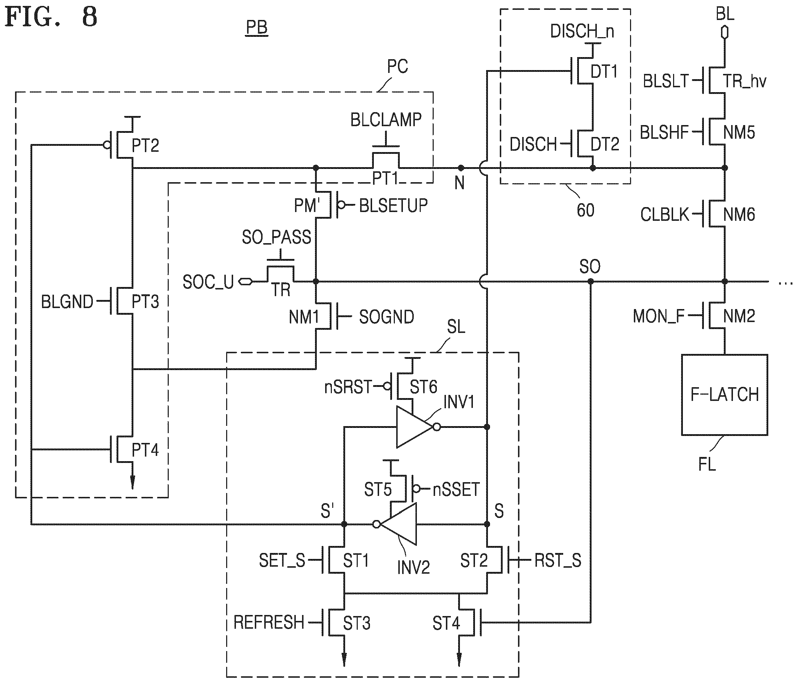

FIG. 8 shows a portion of a page buffer (PB), according to an embodiment.

Referring to FIG. 8, the sensing latch SL may include inverters (e.g., a first inverter INV1 and a second inverter INV2) and transistors (e.g., a first transistor ST1, a second transistor ST2, a third transistor ST3, a fourth transistor ST4, a fifth transistor ST5, and a sixth transistor ST6). The first and second inverters INV1 and INV2 may have a latch structure and may store data in node S and node S'.

The sixth transistor ST6 may be driven by the nSRST signal and may provide a precharge path to the first inverter INV1. The fifth transistor ST5 may be driven by the nSSET signal and may provide a precharge path to the second inverter INV2. The first and second transistors ST1 and ST2 may be N-type transistors, and the fifth and sixth transistors ST5 and ST6 may be P-type transistors. The nSSET signal may have an inverted value of the set signal SET_S, and the nSRST signal may have an inverted value of the reset signal RST_S.

During a program verification operation, when the verification voltage applied to the word line is higher than the threshold voltage of the memory cell, the memory cell may be turned on. The level of the sensing node SO may gradually decrease due to the current flowing in the memory cell. When the level of the sensing node SO is higher than the threshold voltage level of the fourth transistor ST4, the fourth transistor ST4 may be turned on.

In a case where the transistor ST1 is turned on based on the set signal SET_S, when the fourth transistor ST4 is turned on by the level of the sensing node SO, the data of node S' initialized to '1' (e.g., a logic high) is may be changed to '0' (e.g., a logic low) and the data of node S initialized to '0' may be changed to '1'. That is, because the voltage level of the sensing node SO is not sufficiently lowered due to the on-current of the memory cell, the corresponding memory cell may be determined to be an off-cell.

Alternatively or additionally, in a case where the first transistor ST1 is turned on based on the set signal SET_S, when the fourth transistor ST4 is not turned on due to the level of the sensing node SO, the data of node S' initialized to ` 1' may be maintained as ` 1' and the data of node S initialized to '0' may be maintained as `0'. That is, because the voltage level of the sensing node SO is sufficiently low due to the on-current of the memory cell, the corresponding memory cell may be determined to be on-cell.

Referring to FIG. 7, the verification result of the program verification operation using the fine verification voltage Vvfyf may be stored in the sensing latch SL, and the verification result of the program verification operation using the coarse verification voltage Vvfyc may be stored in the forcing latch FL.

A method of determining on-cell/off-cell by turning on the first transistor ST1 based on the set signal SET_S has been described. However, the present disclosure is not limited thereto. For example, on-cell/off-cell may also be determined by turning on the second transistor ST2 based on the reset signal RST_S.

The threshold voltage of the fourth transistor ST4 may be referred to as a sensing trip Sensing_Trip. The Sensing_Trip may also be referred to as a reference level.

The precharge circuit PC may include transistors (e.g., a first precharge transistor PT1, a second precharge transistor PT2, a third precharge transistor PT3, and a fourth precharge transistor PT4). In the bit line setup period of the next program loop, the precharge circuit PC may precharge node N based on the level of node S'.

In some embodiments, after the program verification operation, the data of node S' corresponding to the on-cell may be '1' (e.g., a logic high). When the bit line ground signal BLGND is at the turn-on level, the data of node S' is ` 1', and the bit line clamping control signal BLCLAMP is at the turn-on level, the node N may be discharged by the first, third, and fourth precharge transistors PT1, PT3, and PT4, and thus, the node N may have a ground voltage.

That is, when the memory cell is determined to be on-cell in the program verification period of the previous program loop, the node N may have a ground voltage in the bit line setup period of the next program loop and the bit line BL may be precharged with a ground voltage (e.g., the program allowable voltage Vbl_pgm).

In some embodiments, after the program verification operation, the data of node S' corresponding to the off-cell may be '0' (e.g., a logic low). When the bit line ground signal BLGND is at the turn-on level, the data of node S' is `0', and the bit line clamping control signal BLCLAMP is at the turn-on level, the node N may be precharged by the first and second precharge transistors PT1 and PT2 to have a positive precharge voltage. In some embodiments, node N may have a voltage level clamped by a bit line clamping control signal BLCLAMP.

That is, when the memory cell is determined to be off-cell in the program verification period of the previous program loop, the node N may have a positive precharge voltage in the bit line setup period of the next program loop and the bit line BL may be precharged with a program inhibition voltage Vinhibit clamped by the bit line shut-off signal BLSHF. That is, the program prohibition voltage Vinhibit may have a size obtained by subtracting the threshold voltage level of the fifth transistor NM5 from the voltage level of the bit line shut-off signal BLSHF.

After the bit line setup period, the forcing data stored in the forcing latch FL in the forcing dump period may be transferred to the sensing latch SL.

For example, data '0' may be transferred to node S' of the sensing latch SL for the memory cell included in the forcing area (e.g., second area B in FIG. 7), data ` 1' may be transferred to node S of the sensing latch SL for a memory cell included in a program target area (e.g., first area A in FIG. 7) other than the forcing area.

In the bit line forcing period after the forcing dump period, node N may be precharged with a positive precharge voltage by the first and second precharge transistors PT1 and PT2, for the plurality of memory cells included in the forcing area. In the bit line forcing period, the voltage level of a bit line shut-off signal BLSHF may be lower than the bit line setup period. Accordingly, the forcing voltage Vfc having a level lower than the program inhibition voltage Vinhibit may be provided to the bit line BL.

In the bit line forcing period after the forcing dump period, for memory cells included in the program target area other than the forcing area, node N may be discharged to the ground voltage by the first, third, and fourth precharge transistors PT1, PT3, and PT4, and the ground voltage. That is, the program allowable voltage Vbl_pgm may be provided to the bit line BL.

The discharge circuit 60 may include discharge transistors (e.g., a first discharge transistor DT1 and a second discharge transistor DT2).

The gate terminal of the first discharge transistor DT1 may be connected to the node S, the drain terminal thereof may be connected to the discharge node DISCH n, and the source terminal thereof may be connected to the drain terminal of the second discharge transistor DT2. In some embodiments, the level of the discharge node DISCH n may be greater than the level of the ground voltage.

In the forcing sustain period after the bit line forcing period, the discharge control signal DISCH may be changed to the turn-on level. Accordingly, the second discharge transistor DT2 may be turned on. Because data '1' may be stored in node S for the memory cell included in the forcing area, the first discharge transistor DT1 may be turned on, and node N may be discharged to the level of the discharge node DISCH _n by the first and second discharge transistors DT1 and DT2. In the forcing sustain period, the bit line shut-off signal BLSHF and the bit line select signal BLSLT have a turn-on level, and as a result, the bit line BL may be discharged in the direction of the discharge node DISCH_n. Accordingly, it may be possible to prevent the voltage level of the bit line BL from increasing due to coupling due to the voltage applied to the word line.

According to an embodiment, in the bit line forcing period, by maintaining the voltage level of the bit line BL for the memory cell included in the forcing area at the level of the discharge node DISCH _n, the voltage level of the bit line BL may be prevented from excessively increasing due to coupling with the word line WL.

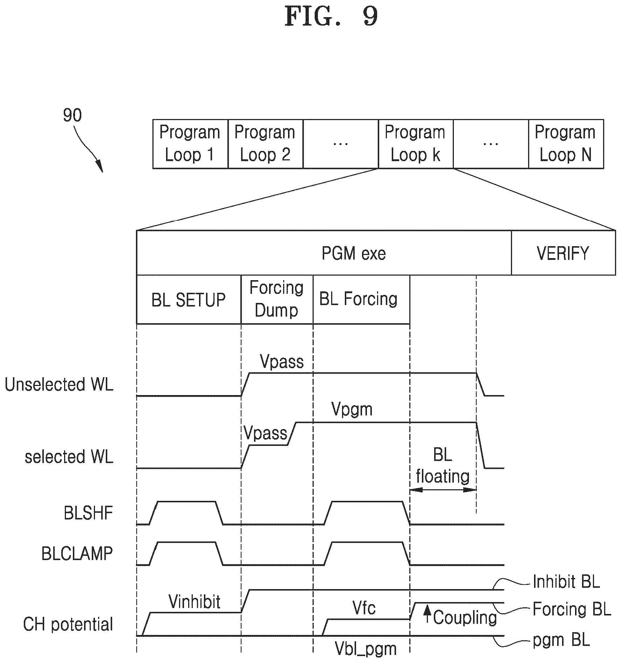

FIG. 9 is a timing diagram 90 illustrating a method of operating a memory device, according to a comparative example.

Referring to FIG. 9, during program operation, a plurality of program loops (e.g., a first program loop 1, a second program loop 2, to a k-th program loop k, to an N-th program loop N, where N is a positive integer greater than one (1), and k is positive integer less than or equal to N) may be performed. The k-th program loop k may include a program execution period PGM exe and a program verification period VERIFY. The description of the k-th program loop may be applied to each program loop of the remaining program loops.

The program execution period may include a bit line setup period BL SETUP, a forcing dump period Forcing Dump, and a bit line forcing period BL forcing.

In the bit line setup period BL SETUP, the bit line shut-off signal BLSHF and a bit line clamping control signal BLCLAMP may transition to the turn-on level. In an embodiment, the bit line selection signal BLSLT may also transition to the turn-on level.

When the bit line setup period ends, a pass voltage Vpass may be applied to the unselected word line. The pass voltage Vpass and a program voltage Vpgm may be sequentially applied to the selected word line. However, the present disclosure is not limited thereto, and only the program voltage Vpgm may be applied to the selected word line, for example.

The results of the program verification period VERIFY of the previous program loop may be stored in the sensing latch SL and the forcing latch FL. Depending on the data stored in the sensing latches SL and forcing latches FL included in the plurality of page buffers, the bit line may be divided into a program inhibition bit line Inhibit BL, a forcing bit line Forcing BL, and a program allowable bit line pgm BL.

When the bit line setup period ends, the forcing dump period may be executed. In the forcing dump period, the forcing data stored in the forcing latch FL may be transferred to the sensing latch SL. In some embodiments, the forcing data stored in the forcing latch FL may be transferred to another data latch.

When the forcing dump period ends, the bit line forcing period may be executed. In the bit line forcing period, a forcing voltage Vfc may be applied to the forcing bit line, and a bit line program allowable voltage Vbl_pgm may be applied to the program allowable bit line.

When the bit line forcing period ends, the bit line shut-off signal BLSHF may have a turn-off level, and the bit line BL may be floating accordingly.

When the bit line BL is floating, the voltage level of the forcing bit line may increase due to coupling by the pass voltage Vpass or the program voltage Vpgm applied to the word line WL. Accordingly, the voltage level of the forcing bit line may become similar to the program inhibition voltage Vinhibit, and programming accuracy for the memory cell connected to the forcing bit line may be lowered.

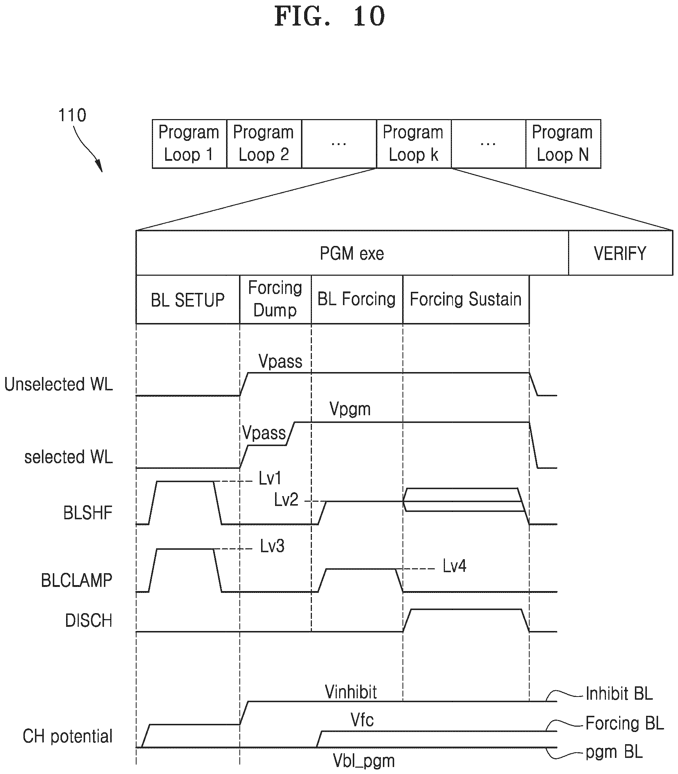

FIG. 10 is a timing diagram 110 illustrating a method of operating a memory device, according to an embodiment. FIG. 10 may be described with reference to FIG. 8. The timing diagram 110 of FIG. 10 may include and/or may be similar in many respects to the timing diagram 90 described above with reference to FIG. 9, and may include additional features not mentioned above. Consequently, repeated descriptions of the timing diagram 110 described above with reference to FIG. 9 may be omitted for the sake of brevity.

Referring to FIG. 10, a program execution period may further include a forcing sustain period Forcing Sustain. When the bit line forcing period ends, the forcing sustain period may be executed.

In the forcing sustain period, a program voltage Vpgm may be applied to the selected word line, and a pass voltage Vpass may be applied to the unselected word line.

In the bit line setup period, the bit line shut-off signal BLSHF may transition to the first level Lv1 (e.g., 3.4 Volts (V)) for a certain period of time. The bit line shut-off signal BLSHF may transition to the second level Lv2 (e.g., 0.7V) during the bit line forcing period and maintain the second level Lv2 during the forcing sustain period. The second level Lv2 may be lower than the first level Lv1. A voltage obtained by subtracting the threshold voltage of the fifth transistor NM5 from the voltage of the bit line shut-off signal BLSHF may be transmitted to the bit line BL. Accordingly, a forcing voltage Vfc lower than the program prohibition voltage Vinhibit may be provided to the bit line BL by lowering the voltage level of the bit line shut-off signal BLSHF in the bit line forcing period and the bit line sustain period.

In some embodiments, the bit line shut-off signal BLSHF may transition to the second level Lv2 in the bit line forcing period and may transition to a level different from the second level Lv2 in the forcing sustain period. For example, in the forcing sustain period, the voltage level of the bit line shut-off signal BLSHF may be lower or higher than the second level Lv2.

In the bit line setup period, the bit line clamping control signal BLCLAMP may transition to the third level Lv3 for a certain period of time. The bit line clamping control signal BL CLAMP may transition to the fourth level Lv4 for a certain period of time during the bit line forcing period. The bit line clamping control signal BLCLAMP may be maintained at 0V during the forcing sustain period. Because the voltage level of node N has a value clamped by the first precharge transistor PT1 that receives the bit line clamping control signal BLCLAMP, the voltage level of node N may be lowered by lowering the value of the clamping control signal BLCLAMP.

When the data of node S for the memory cell included in the forcing area is '1', the first discharge transistor DT1 may be turned on. Therefore, as shown in FIG. 10, in the forcing sustain period, node N may be maintained at the level of the discharge node DISCH _n by transitioning the discharge control signal DSCH to the turn-on level for a certain period of time.

Because the forcing bit line is discharged in the node N direction, even if the voltage of the forcing bit line increases due to coupling by the voltage applied to the word line, the voltage level of the forcing bit line may be maintained constant.

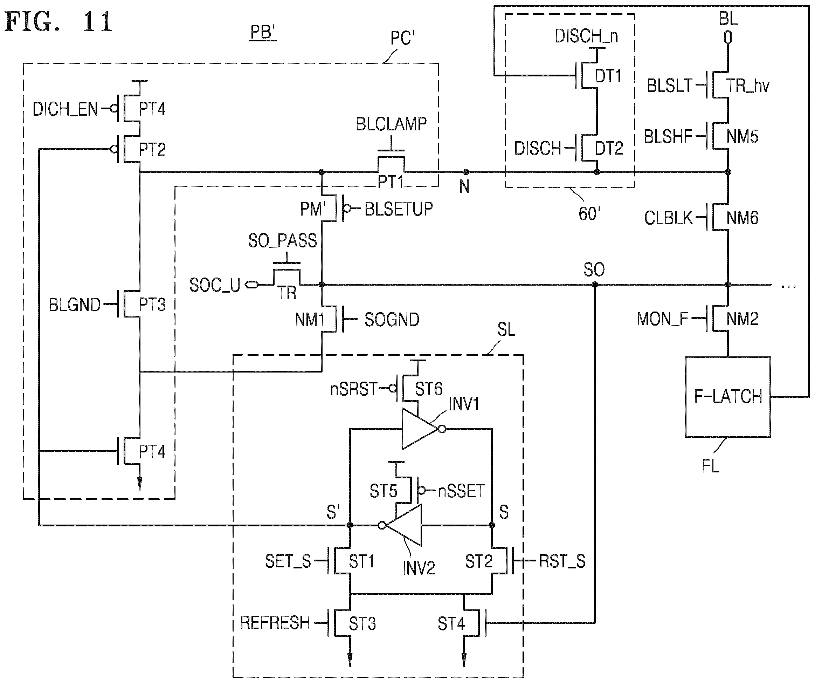

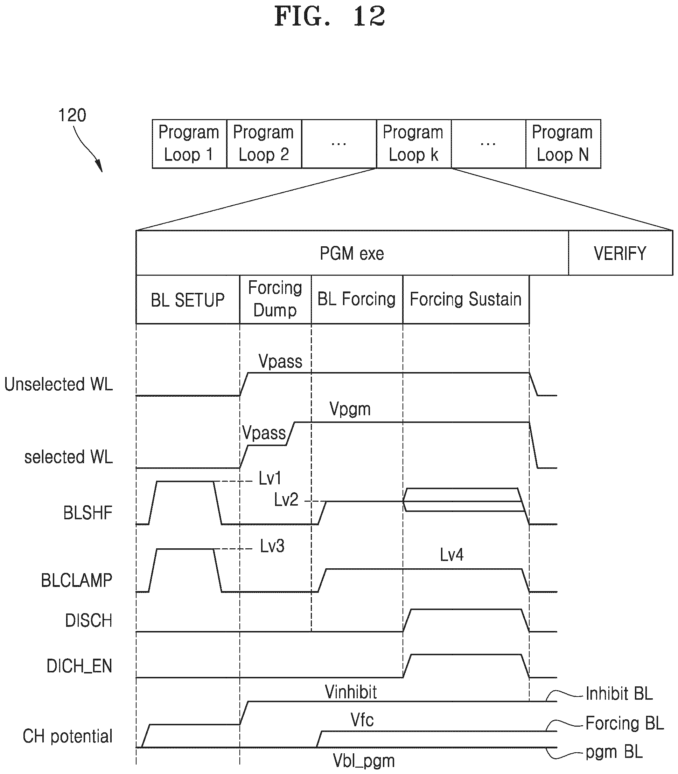

FIG. 11 is a diagram showing a portion of a page buffer PB', according to an embodiment. FIG. 12 is a timing diagram 120 illustrating a method of operating a memory device, according to an embodiment.

The page buffer PB' of FIG. 11 may include and/or may be similar in many respects to the page buffer PB described above with reference to FIG. 8, and may include additional features not mentioned above. Consequently, repeated descriptions of the page buffer PB' described above with reference to FIG. 8 may be omitted for the sake of brevity. Furthermore, the timing diagram 120 of FIG. 12 may include and/or may be similar in many respects to the timing diagrams 90 and 110 described above with reference to FIGS. 9 and 10, and may include additional features not mentioned above. Consequently, repeated descriptions of the timing diagram 120 described above with reference to FIGS. 9 and 10 may be omitted for the sake of brevity.

Unlike FIG. 8, in FIG. 11, the gate terminal of the first discharge transistor DT1 included in the discharge circuit 60' may be connected to the forcing latch FL. Accordingly, the forcing data stored in the forcing latch FL may be directly provided to the gate terminal of the first discharge transistor DT1. Data '1' may be provided to the gate terminal of the first discharge transistor DT1 for the memory cell included in the forcing area. Data '0' may be provided to the gate terminal of the first discharge transistor DT1 for a memory cell included in a program target area other than the forcing area.

Unlike FIG. 8, in FIG. 11, the precharge circuit PC' may further include a fourth precharge transistor PT4. The gate terminal of the fourth precharge transistor PT4 may receive a discharge enable signal DIC_EN, the source terminal thereof may be connected to a positive power supply voltage, and the drain terminal thereof may be connected to the source terminal of a second precharge transistor PT2.

Referring to FIG. 12, in the forcing sustain period, the first discharge transistor DT1 may receive forcing data from the forcing latch FL. For the memory cell included in the forcing area, the forcing data is '1', and as a result, the first discharge transistor DT1 may be turned on. For a memory cell included in a program target area other than the forcing area, the forcing data is `0', and as a result, the first discharge transistor DT1 may be turned off.

In the forcing sustain period, the discharge control signal DISCH may have a turn-on level for a certain period of time. Accordingly, the second discharge transistor DT2 may be turned on.

Unlike FIG. 8, in FIG. 11, a bit line clamping control signal BLCLAMP may maintain a fourth level Lv4 in the forcing sustain period. In the forcing sustain period, because a discharge enable signal DICH_EN has a turn-on level, precharge by the transistor PT4 may not occur. Therefore, as in FIG. 10, precharge of node N by the precharge circuit PC' may not occur.

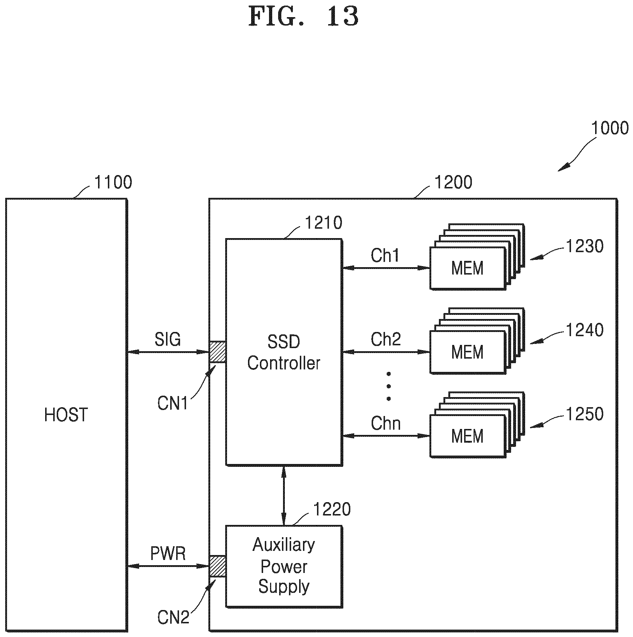

FIG. 13 is a block diagram showing an example of applying a memory system to a solid-state drive (SSD) system, according to an embodiment.

Referring to FIG. 13, an SSD system 1000 may include a host 1100 and SSD 1200. The SSD 1200 may exchange a signal SIG with the host 1100 through a signal connector CN1 and may receive power PWR through a power connector CN2. The SSD 1200 may include an SSD controller 1210, an auxiliary power supply 1220, and a plurality of memory devices (e.g., first memory devices 1230, second memory devices 1240, to n-th memory devices 1250, where n is a positive integer greater than one (1)). The first to n-th memory devices 1230 to 1250 may each be connected to the SSD controller 1210 through channels (e.g., a first channel Ch1, a second channel Ch2, to n-th channel Chn).

The plurality of memory devices 1230 to 1250 may be implemented using the memory device 10 described above with reference to FIGS. 1 to 12. That is, each memory device of the plurality of memory devices 1230 to 1250 may generate a discharge path for the forcing bit line in the forcing sustain period after the bit line forcing period, thereby potentially preventing excessive voltage rise of the forcing bit line caused by coupling due to the voltage applied to the word line.

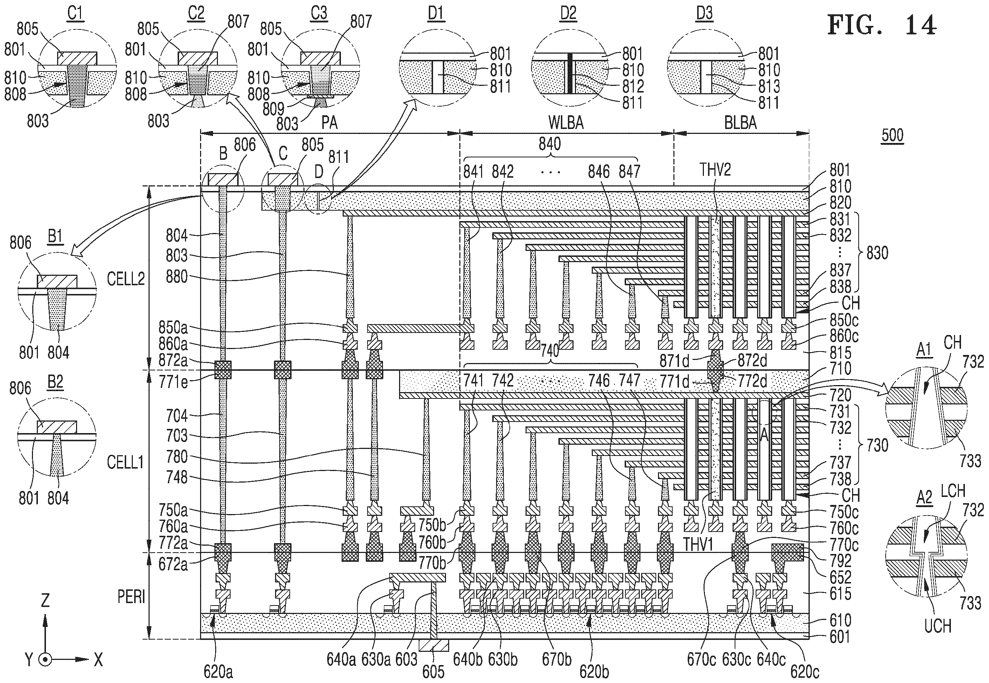

FIG. 14 is a view illustrating a memory device 500 according to some embodiments.

Referring to FIG. 14, the memory device 500 may have a chip-to-chip (C2C) structure. The C2C structure may refer to a structure obtained by connecting at least one upper chip including a cell region and a lower chip including a peripheral circuit region PERI to each other by using a bonding method after separately manufacturing the at least one upper chip including the cell region and the lower chip including the peripheral circuit region PERI. Alternatively or additionally, the bonding method may refer to a method of electrically and/or physically connecting a bonding metal pattern formed in an uppermost metal layer of the upper chip to a bonding metal pattern formed in an uppermost metal layer of the lower chip to each other. For example, when the bonding metal patterns are formed of copper (Cu), the bonding method may be referred to as a Cu-Cu bonding method. Alternatively or additionally, the bonding metal patterns may be formed of aluminum (Al), tungsten (W), or the like. However, the present disclosure is not limited in this regard.

The memory device 500 may include the at least one upper chip including the cell region. For example, as shown in FIG. 14, the memory device 500 may include two (2) upper chips. However, the number of the upper chips may not be limited in this regard. For example, when the memory device 500 includes the two (2) upper chips, a first upper chip including a first cell region CELL1, a second upper chip including a second cell region CELL2 and the lower chip including the peripheral circuit region PERI may be manufactured separately, and the first upper chip, the second upper chip and the lower chip may be connected to each other by the bonding method to manufacture the memory device 500.

In an embodiment, the first upper chip may be turned over and then may be connected to the lower chip by the bonding method. Alternatively or additionally, the second upper chip may be turned over and connected to the first upper chip by the bonding method. Hereinafter, upper and lower portions of each chip of the first and second upper chips may be referred to based on orientations of the first and second upper chips before each chip of the first and second upper chips have been turned over. That is, an upper portion of the lower chip may refer to an upper portion based on a +Z-axis direction, and the upper portion of each chip of the first and second upper chips may refer to an upper portion defined based on a -Z-axis direction in FIG. 14. However, the present disclosure may not be limited in this regard. In certain embodiments, one of the first upper chip and the second upper chip may be turned over and may be connected to a corresponding chip by the bonding method.

In the memory device 500, each of the peripheral circuit region PERI and the first and second cell regions CELL1 and CELL2 may include an external pad bonding region PA, a word line bonding region WLBA, and a bit line bonding region BLBA.

The peripheral circuit region PERI may include a first substrate 610 and a plurality of circuit elements (e.g., a first circuit element 620a, a second circuit element 620b, and a third circuit element 620c) formed on the first substrate 610. An interlayer insulating layer 615 including one or more insulating layers may be provided on the plurality of circuit elements 620a to 620c, and a plurality of metal lines electrically connected to the plurality of circuit elements 620a to 620c may be provided in the interlayer insulating layer 615. For example, the plurality of metal lines may include first metal lines (e.g., a first metal line 630a, a second metal line 630b, and a third metal line 630c) connected to the plurality of circuit elements 620a to 620c, and second metal lines (e.g., a fourth metal line 640a, a fifth metal line 640b, and a sixth metal line 640c) formed on the first metal lines 630a to 630c. The plurality of metal lines may be formed of at least one of various conductive materials. For example, the first metal lines 630a to 630c may be formed of a material having a relatively high electrical resistivity, such as, but not limited to, tungsten (W). The second metal lines 640a to 640c may be formed of a material having a relatively low electrical resistivity, such as, but not limited to, copper (Cu).

The first metal lines 630a to 630c and the second metal lines 640a to 640c are not limited to the metal lines illustrated and described in the present embodiments. In certain embodiments, at least one or more additional metal lines may be formed on the second metal lines 640a to 640c. In such embodiments, the second metal lines 640a to 640c may be formed of aluminum (Al), and at least some of the additional metal lines formed on the second metal lines 640a to 640c may be formed of copper (Cu) having an electrical resistivity lower than that of the aluminum (Al) of the second metal lines 640a to 640c.

The interlayer insulating layer 615 may be disposed on the first substrate 610 and may include an insulating material such as, but not be limited to, silicon oxide (SiO), silicon nitride (SiN), or the like.

Each of the first and second cell regions CELL 1 and CELL2 may include at least one memory block. The first cell region CELL1 may include a second substrate 710 and a common source line 720. A plurality of word lines 730 (e.g., a first word line 731, a second word line 732, to a seventh word line 737, and an eighth word line 738) may be stacked on the second substrate 710 in a direction (e.g., the Z-axis direction) perpendicular to a top surface of the second substrate 710. String selection lines and a ground selection line may be disposed on and/or under the plurality of word lines 730. The plurality of word lines 730 may be disposed between the string selection lines and the ground selection line. In a similar manner, the second cell region CELL2 may include a third substrate 810 and a common source line 820, and a plurality of word lines 830 (e.g., a first word line 831, a second word line 832, to a seventh word line 837, and an eighth word line 838) may be stacked on the third substrate 810 in a direction (e.g., the Z-axis direction) perpendicular to a top surface of the third substrate 810. Each of the second substrate 710 and the third substrate 810 may be formed of at least one of various materials such as, but not limited to, a silicon (Si) substrate, a silicon-germanium (Si-Ge) substrate, a germanium (Ge) substrate, and/or a substrate having a single-crystalline epitaxial layer grown on a single-crystalline silicon substrate. A plurality of channel structures CH may be formed in each cell region of the first and second cell regions CELL1 and CELL2.

In some embodiments, as shown in a region A1, the channel structure CH may be provided in the bit line bonding region BLBA and may extend in the direction perpendicular to the top surface of the second substrate 710 to penetrate the word lines 730, the string selection lines, and the ground selection line. The channel structure CH may include a data storage layer, a channel layer, and a filling insulation layer. The channel layer may be electrically connected to a first metal line 750c and a second metal line 760c in the bit line bonding region BLBA. For example, the second metal line 760c may be a bit line and may be connected to the channel structure CH through the first metal line 750c. The bit line 760c may extend in a first direction (e.g., a Y-axis direction) that may be parallel to the top surface of the second substrate 710.

In some embodiments, as shown in a region A2, the channel structure CH may include a lower channel LCH and an upper channel UCH, which may be connected to each other. For example, the channel structure CH may be formed by a process of forming the lower channel LCH and a process of forming the upper channel UCH. The lower channel LCH may extend in the direction perpendicular to the top surface of the second substrate 710 to penetrate the common source line 720 and lower word lines (e.g., a first lower word line 731 and a second lower word line 732). The lower channel LCH may include a data storage layer, a channel layer, and a filling insulation layer and may be connected to the upper channel UCH. The upper channel UCH may penetrate the third to eighth upper word lines 733 to 738. The upper channel UCH may include a data storage layer, a channel layer, and a filling insulation layer, and the channel layer of the upper channel UCH may be electrically connected to the first metal line 750c and the second metal line 760c. As a length of a channel increases, due to characteristics of manufacturing processes, it may be difficult to form a channel having a substantially uniform width. In an embodiment, the memory device 500 may include a channel having improved width uniformity due to the lower channel LCH and the upper channel UCH which may be formed by the processes being performed sequentially.

When the channel structure CH includes the lower channel LCH and the upper channel UCH as shown in the region A2, a word line located near to a boundary between the lower channel LCH and the upper channel UCH may be a dummy word line. For example, the word lines 732 and 733 adjacent to the boundary between the lower channel LCH and the upper channel UCH may be the dummy word lines. That is, data may not be stored in memory cells connected to the dummy word line. Alternatively or additionally, the number of pages corresponding to the plurality of memory cells connected to the dummy word line may be less (e.g., smaller) than the number of pages corresponding to the plurality of memory cells connected to a related word line. A voltage level applied to the dummy word line may be different from a voltage level applied to the related word line. Accordingly, it may be possible to reduce an influence of a non-uniform channel width between the lower and upper channels LCH and UCH on an operation of the memory device 500.

In an embodiment, the number of the lower word lines 731 and 732 penetrated by the lower channel LCH may be less than the number of the upper word lines 733 to 738 penetrated by the upper channel UCH in the region A2. However, the present disclosure is not limited thereto. For example, in certain embodiments, the number of the lower word lines penetrated by the lower channel LCH may be greater than or equal to the number of the upper word lines penetrated by the upper channel UCH. Alternatively or additionally, structural features and connection relation of the channel structure CH disposed in the second cell region CELL2 may be substantially the same as those of the channel structure CH disposed in the first cell region CELL1.

In the bit line bonding region BLBA, a first through-electrode via (TSV) THV1 may be provided in the first cell region CELL1, and a second TSV THV2 may be provided in the second cell region CELL2. As shown in FIG. 14, the first TSV THV1 may penetrate the common source line 720 and the plurality of word lines 730. In certain embodiments, the first TSV THV1 may further penetrate the second substrate 710. The first TSV THV1 may include a conductive material. Alternatively or additionally, the first TSV THV1 may include a conductive material surrounded by an insulating material. The second TSV THV2 may have a substantially similar and/or the same shape and/or structure as the first TSV THV1.

In some embodiments, the first TSV THV1 and the second TSV THV2 may be electrically connected to each other through a first through-metal pattern 772d and a second through-metal pattern 872d. The first through-metal pattern 772d may be formed at a bottom end of the first upper chip including the first cell region CELL1, and the second through-metal pattern 872d may be formed at a top end of the second upper chip including the second cell region CELL2. The first TSV THV1 may be electrically connected to the first metal line 750c and the second metal line 760c. A lower via 771d may be formed between the first TSV THV1 and the first through-metal pattern 772d, and an upper via 871d may be formed between the second TSV THV2 and the second through-metal pattern 872d. The first through-metal pattern 772d and the second through-metal pattern 872d may be connected to each other by the bonding method.

Alternatively or additionally, in the bit line bonding region BLBA, an upper metal pattern 652 may be formed in an uppermost metal layer of the peripheral circuit region PERI. An upper metal pattern 792 having a substantially similar and/or the same shape as the upper metal pattern 652 may be formed in an uppermost metal layer of the first cell region CELL 1. The upper metal pattern 792 of the first cell region CELL 1 and the upper metal pattern 652 of the peripheral circuit region PERI may be electrically connected to each other by the bonding method. In the bit line bonding region BLBA, the bit line 760c may be electrically connected to a page buffer included in the peripheral circuit region PERI. For example, some of the circuit elements 620c of the peripheral circuit region PERI may constitute the page buffer, and the bit line 760c may be electrically connected to the circuit elements 620c constituting the page buffer through an upper bonding metal pattern 770c of the first cell region CELL1 and an upper bonding metal pattern 670c of the peripheral circuit region PERI.

Continuing to refer to FIG. 14, in the word line bonding region WLBA, the word lines 730 of the first cell region CELL1 may extend in a second direction (e.g., an X-axis direction) parallel to the top surface of the second substrate 710. The word lines 730 may be connected to a plurality of cell contact plugs 740 (e.g., a first cell contact plug 741, a second cell contact plug, to a sixth cell contact plug 746, and a seventh cell contact plug 747). First metal lines 750b and second metal lines 760b may be sequentially connected onto the cell contact plugs 740 connected to the word lines 730. In the word line bonding region WLBA, the cell contact plugs 740 may be connected to the peripheral circuit region PERI through upper bonding metal patterns 770b of the first cell region CELL1 and upper bonding metal patterns 670b of the peripheral circuit region PERI.

The cell contact plugs 740 may be electrically connected to a row decoder included in the peripheral circuit region PERI. For example, some of the circuit elements 620b of the peripheral circuit region PERI may constitute the row decoder, and the cell contact plugs 740 may be electrically connected to the circuit elements 620b constituting the row decoder through the upper bonding metal patterns 770b of the first cell region CELL1 and the upper bonding metal patterns 670b of the peripheral circuit region PERI. In some embodiments, an operating voltage of the circuit elements 620b constituting the row decoder may be different from an operating voltage of the circuit elements 620c constituting the page buffer. For example, the operating voltage of the circuit elements 620c constituting the page buffer may be greater than the operating voltage of the circuit elements 620b constituting the row decoder.

In the word line bonding region WLBA, the word lines 830 of the second cell region CELL2 may extend in the second direction (e.g., the X-axis direction) parallel to the top surface of the third substrate 810. The word lines 830 may be connected to a plurality of cell contact plugs 840 (e.g., a first cell contact plug 841, a second cell contact plug 842, to a sixth cell contact plug 846, and a seventh cell contact plug 847). The cell contact plugs 840 may be connected to the peripheral circuit region PERI through an upper metal pattern of the second cell region CELL2 and lower and upper metal patterns and a cell contact plug 348 of the first cell region CELL1.

In the word line bonding region WLBA, the upper bonding metal patterns 770b may be formed in the first cell region CELL1, and the upper bonding metal patterns 670b may be formed in the peripheral circuit region PERI. The upper bonding metal patterns 770b of the first cell region CELL1 and the upper bonding metal patterns 670b of the peripheral circuit region PERI may be electrically connected to each other by the bonding method. The upper bonding metal patterns 770b and the upper bonding metal patterns 670b may be formed of a material such as, but not limited to, aluminum (Al), copper (Cu), tungsten (W), or the like.

In the external pad bonding region PA, a lower metal pattern 771e may be formed in a lower portion of the first cell region CELL1, and an upper metal pattern 872a may be formed in an upper portion of the second cell region CELL2. The lower metal pattern 771e of the first cell region CELL1 and the upper metal pattern 872a of the second cell region CELL2 may be connected to each other by the bonding method in the external pad bonding region PA. Alternatively or additionally, an upper metal pattern 772a may be formed in an upper portion of the first cell region CELL1, and an upper metal pattern 672a may be formed in an upper portion of the peripheral circuit region PERI. The upper metal pattern 772a of the first cell region CELL1 and the upper metal pattern 672a of the peripheral circuit region PERI may be connected to each other by the bonding method.

Common source line contact plugs 780 and 880 may be disposed in the external pad bonding region PA. The common source line contact plugs 780 and 880 may be formed of a conductive material such as, but not limited to, a metal, a metal compound, a doped polysilicon, or the like. The common source line contact plug 780 of the first cell region CELL1 may be electrically connected to the common source line 720, and the common source line contact plug 880 of the second cell region CELL2 may be electrically connected to the common source line 820. A first metal line 750a and a second metal line 760a may be sequentially stacked on the common source line contact plug 780 of the first cell region CELL1, and a first metal line 850a and a second metal line 860a may be sequentially stacked on the common source line contact plug 880 of the second cell region CELL2.

I/O pads (e.g., a first I/O pad 605, a second I/O pad 805, and a third I/O pad 806) may be disposed in the external pad bonding region PA. Referring to FIG. 14, a lower insulating layer 611 may cover at least a portion of a bottom surface of the first substrate 610, and the first I/O pad 605 may be formed on the lower insulating layer 611. The first I/O pad 605 may be connected to at least one of a plurality of the circuit elements 620a disposed in the peripheral circuit region PERI through a first I/O contact plug 603 and may be separated from the first substrate 610 by the lower insulating layer 611. Alternatively or additionally, a side insulating layer may be disposed between the first I/O contact plug 603 and the first substrate 610 to electrically isolate the first I/O contact plug 603 from the first substrate 610.

An upper insulating layer 801 covering a top surface of the third substrate 810 may be formed on the third substrate 810. The second I/O pad 805 and/or the third I/O pad 806 may be disposed on the upper insulating layer 801. The second I/O pad 805 may be connected to at least one of the plurality of circuit elements 620a disposed in the peripheral circuit region PERI through second I/O contact plugs 803 and 703, and the third I/O pad 806 may be connected to at least one of the plurality of circuit elements 620a disposed in the peripheral circuit region PERI through third I/O contact plugs 804 and 704.

In some embodiments, the third substrate 810 may not be disposed in a region in which the I/O contact plug has been disposed. For example, as shown in a region B, the third I/O contact plug 804 may be separated from the third substrate 810 in a direction parallel to the top surface of the third substrate 810 and may penetrate an interlayer insulating layer 815 of the second cell region CELL2 so as to be connected to the third I/O pad 806. The third I/O contact plug 804 may be formed by at least one of various processes. That is, the present disclosure is not limited in this regard.

In some embodiments, as shown in a region B1, the third I/O contact plug 804 may extend in a third direction (e.g., the Z-axis direction), and a diameter of the third I/O contact plug 804 may become progressively greater (e.g., larger, wider) toward the upper insulating layer 801. That is, a diameter of the channel structure CH described in the region A1 may become progressively less (e.g., smaller, narrower) toward the upper insulating layer 801, but the diameter of the third I/O contact plug 804 may become progressively greater toward the upper insulating layer 801. For example, the third I/O contact plug 804 may be formed after the second cell region CELL2 and the first cell region CELL1 are bonded to each other by the bonding method.

In certain embodiments, as shown in a region B2, the third I/O contact plug 804 may extend in the third direction (e.g., the Z-axis direction), and a diameter of the third I/O contact plug 804 may become progressively less (e.g., smaller, narrower) toward the upper insulating layer 801. That is, like the channel structure CH, the diameter of the third I/O contact plug 804 may become progressively less toward the upper insulating layer 801. For example, the third I/O contact plug 804 may be formed together with the cell contact plugs 840 before the second cell region CELL2 and the first cell region CELL1 may be bonded to each other.

In certain embodiments, the I/O contact plug may overlap with the third substrate 810. For example, as shown in regions C1, C2, and C3, the second I/O contact plug 803 may penetrate the interlayer insulating layer 815 of the second cell region CELL2 in the third direction (e.g., the Z-axis direction) and may be electrically connected to the second I/O pad 805 through the third substrate 810. A connection structure of the second I/O contact plug 803 and the second I/O pad 805 may be realized by various methods. That is, the present disclosure is not limited in this regard.

In some embodiments, as shown in the region C1, an opening 808 may be formed to penetrate the third substrate 810, and the second I/O contact plug 803 may be connected directly to the second I/O pad 805 through the opening 808 formed in the third substrate 810. That is, as shown in the region C1, a diameter of the second I/O contact plug 803 may become progressively greater (e.g., larger, wider) toward the second I/O pad 805. However, the present disclosure is not limited thereto. For example, in certain embodiments, the diameter of the second I/O contact plug 803 may become progressively less (e.g., smaller, narrower) toward the second I/O pad 805.

In certain embodiments, as shown in the region C2, the opening 808 penetrating the third substrate 810 may be formed, and a contact 807 may be formed in the opening 808. An end of the contact 807 may be connected to the second I/O pad 805, and another end of the contact 807 may be connected to the second I/O contact plug 803. Thus, the second I/O contact plug 803 may be electrically connected to the second I/O pad 805 through the contact 807 in the opening 808. That is, a diameter of the contact 807 may become progressively greater (e.g., larger, wider) toward the second I/O pad 805, and a diameter of the second I/O contact plug 803 may become progressively less (e.g., smaller, narrower) toward the second I/O pad 805. For example, the second I/O contact plug 803 may be formed together with the cell contact plugs 840 before the second cell region CELL2 and the first cell region CELL1 may be bonded to each other, and the contact 807 may be formed after the second cell region CELL2 and the first cell region CELL1 may be bonded to each other.

In certain embodiments, as shown in the region C3, a stopper 809 may further be formed on a bottom end of the opening 808 of the third substrate 810, as compared with the embodiments of the region C2. The stopper 809 may be a metal line formed in a same layer as the common source line 820. Alternatively or additionally, the stopper 809 may be a metal line formed in a same layer as at least one of the word lines 830. The second I/O contact plug 803 may be electrically connected to the second I/O pad 805 through the contact 807 and the stopper 809.

Similarly to the second and third I/O contact plugs 803 and 804 of the second cell region CELL2, a diameter of each contact plug of the second and third I/O contact plugs 703 and 704 of the first cell region CELL1 may become progressively less (e.g., smaller, narrower) toward the lower metal pattern 771e and/or may become progressively greater (e.g., larger, wider) toward the lower metal pattern 771e.

In some embodiments, a slit 811 may be formed in the third substrate 810. For example, the slit 811 may be formed at a certain position of the external pad bonding region PA. For example, as shown in regions D1, D2, and D3, the slit 811 may be located between the second I/O pad 805 and the cell contact plugs 840 when viewed in a plan view. Alternatively or additionally, the second I/O pad 805 may be located between the slit 811 and the cell contact plugs 840 when viewed in a plan view.

In some embodiments, as shown in the region D1, the slit 811 may be formed to penetrate the third substrate 810. For example, the slit 811 may be used to prevent the third substrate 810 from being finely cracked when the opening 808 is formed. However, the present disclosure is not limited thereto. For example, in certain embodiments, the slit 811 may be formed to have a depth ranging from about 60% to about 70% of a thickness of the third substrate 810.

In certain embodiments, as shown in the region D2, a conductive material 812 may be formed in the slit 811. The conductive material 812 may be used to discharge a leakage current occurring in driving of the circuit elements in the external pad bonding region PA to the outside. That is, the conductive material 812 may be connected to an external ground line.

In certain embodiments, as shown in the region D3, an insulating material 813 may be formed in the slit 811. For example, the insulating material 813 may be used to electrically isolate the second I/O pad 805 and the second I/O contact plug 803 disposed in the external pad bonding region PA from the word line bonding region WLBA. When the insulating material 813 is formed in the slit 811, it may be possible to prevent a voltage provided through the second I/O pad 805 from affecting a metal layer disposed on the third substrate 810 in the word line bonding region WLBA.

In certain embodiments, the first to third I/O pads 605, 805 and 806 may be selectively formed. For example, the memory device 500 may be realized to include only the first I/O pad 605 disposed on the first substrate 610, to include only the second I/O pad 805 disposed on the third substrate 810, and/or to include only the third I/O pad 806 disposed on the upper insulating layer 801.

In some embodiments, at least one of the second substrate 710 of the first cell region CELL1 and/or the third substrate 810 of the second cell region CELL2 may be used as a sacrificial substrate and may be completely and/or partially removed before and/or after a bonding process. An additional layer may be stacked after the removal of the substrate. For example, the second substrate 710 of the first cell region CELL1 may be removed before and/or after the bonding process of the peripheral circuit region PERI and the first cell region CELL1, and an insulating layer covering a top surface of the common source line 720 and/or a conductive layer for connection may be formed. Similarly, the third substrate 810 of the second cell region CELL2 may be removed before and/or after the bonding process of the first cell region CELL1 and the second cell region CELL2, and the upper insulating layer 801 covering a top surface of the common source line 820 and/or a conductive layer for connection may be formed.

The memory cell array 100 of FIG. 1 may be included in the first cell region CELL1 and/or the second cell region CELL2, and the peripheral circuit 200 of FIG. 1 may be included in the peripheral circuit region PERI.

## Claims

1. A memory device (10), comprising:
a memory cell array (100) comprising a plurality of memory cells; and
a page buffer circuit (210) comprising a plurality of page buffers (PB) respectively coupled to the plurality of memory cells through a plurality of bit lines (BL),
wherein each page buffer of the plurality of page buffers (PB) comprises:
a first transistor (NM5) coupling a corresponding bit line of the plurality of bit lines (BL) to a first node (N), based on a first control signal (BLSHF);
a second transistor (NM6) coupling the first node (N) to a sensing node (SO);
a sensing latch (SL) configured to sense data stored in a corresponding memory cell, based on a first voltage level of the sensing node (SO);
a forcing latch (FL) configured to store forcing data;
a first discharge transistor (DT1) comprising a first gate terminal configured to receive the forcing data, a first end of the first discharge transistor (DT1) being coupled to a discharge node (DISCH _n), and a second end of the first discharge transistor (DT1) being coupled to a second node; and
a second discharge transistor (DT2) comprising a second gate terminal configured to receive a discharge control signal (DISCH), a third end of the second discharge transistor (DT2) being coupled to the second node, and a fourth end of the second discharge transistor (DT2) being coupled to the first node (N).

2. The memory device (10) of claim 1, wherein the forcing latch (FL) is further configured to transfer the forcing data to the sensing latch (SL) during a forcing dump period, and
wherein the forcing data transferred to the sensing latch (SL) is provided to the first gate terminal of the first discharge transistor (DT1).

3. The memory device (10) of claim 1 or 2, wherein a second voltage level of the discharge node (DISCH _n) is higher than a ground level and lower than a level of a program inhibition voltage.

4. The memory device (10) of any one of claims 1 to 3, further comprising:
a precharge circuit (PC) comprising a third transistor (PT1) configured to precharge the first node (N), based on a second control signal (BLCLAMP),
wherein the second control signal (BLCLAMP) is activated during a bit line forcing period,
wherein the discharge control signal (DISCH) is activated during a forcing sustain period, and
wherein the first control signal (BLSHF) is activated during the bit line forcing period and the forcing sustain period.

5. The memory device (10) of claim 4, wherein the first control signal (BLSHF) transitions to a first level (Lv1) during a bit line setup period,
wherein the first control signal (BLSHF) transitions to a second level (Lv2) during the bit line forcing period, and
wherein the second level (Lv2) is lower than the first level (Lv1).

6. The memory device (10) of claim 5, wherein the first control signal (BLSHF) transitions to a level different from the second level (Lv2) during the forcing sustain period.

7. The memory device (10) of any one of claims 4 to 6, wherein the second control signal (BLCLAMP) transitions to a third level (Lv3) during a bit line setup period,
wherein the second control signal (BLCLAMP) transitions to a fourth level (Lv4) during the bit line forcing period, and
wherein the fourth level (Lv4) is lower than the third level (Lv3).

8. The memory device (10) of any one of claims 1 to 7, wherein the first gate terminal of the first discharge transistor (DT1) is coupled to the forcing latch (FL), and
wherein the first gate terminal of the first discharge transistor (DT1) is configured to receive the forcing data from the forcing latch (FL).

9. The memory device (10) of any one of claims 1 to 8, further comprising a precharge circuit (PC) which comprises:
a third transistor (PT1) configured to precharge the first node (N), based on a second control signal (BLCLAMP);
a fourth transistor (PT4) comprising a fourth gate terminal configured to receive a third control signal (DICH_EN), a fifth end of the fourth transistor (PT4) being coupled to a positive power voltage; and
a fifth transistor (PT2) comprising a fifth gate terminal is coupled to an output node of the sensing latch (SL), a seventh end of the fifth transistor (PT2) being coupled to a sixth end of the fourth transistor (PT4), and an eighth end of the fifth transistor (PT2) being coupled to a ninth end of the third transistor (PT1).

10. An operating method of a memory device (10), the operating method comprising:
turning on a first transistor (NM5) coupling a bit line to a first node (N), in a bit line setup period;
turning on a second transistor (PT1) that precharges the first node (N), in the bit line setup period;
transferring data stored in a forcing latch (FL) to a sensing latch (SL), in a forcing dump period following the bit line setup period;
turning on the first transistor (NM5), in a bit line forcing period following the forcing dump period and in a forcing sustain period following the bit line forcing period;
turning on the second transistor (PT1) in the bit line forcing period;
turning off the second transistor (PT1) in the forcing sustain period; and
turning on, in the forcing sustain period, a third transistor (DT2) comprising a first end coupled to a discharge node (DISCH) and a second end coupled to the first node (N).

11. The operating method of claim 10, wherein the turning on of the first transistor (NM5), in the bit line setup period, comprises applying a first control signal (BLSHF) to the first transistor (NM5),
wherein the turning on of the first transistor (NM5) in the bit line forcing period and the forcing sustain period comprises applying a second control signal (BLSHF) to the first transistor (NM5), in the bit line forcing period, and
wherein a second level (Lv2) of the second control signal (BLSHF) is lower than a first level (Lv1) of the first control signal (BLSHF).

12. The operating method of claim 11, wherein the turning on of the first transistor (NM5) in the bit line forcing period and the forcing sustain period comprises:
applying a control signal of a level different from the second control signal (BLSHF) to the first transistor (NM5), in the forcing sustain period.

13. The operating method of any one of claims 10 to 12, wherein the turning on of the second transistor (PT1) in the bit line setup period, comprises applying a third control signal (BLCLAMP) to the second transistor (PT1),
wherein the turning on of the second transistor (PT1) in the bit line forcing period comprises applying a fourth control signal (BLCLAMP) to the second transistor (PT1), and
wherein a fourth level (Lv4) of the fourth control signal (BLCLAMP) is lower than a third level (Lv3) of the third control signal (BLCLAMP).

14. The operating method of any one of claims 10 to 13, wherein a voltage level of the discharge node (DISCH) is higher than a ground level and lower than a level of a program inhibition voltage.

15. The operating method of any one of claims 10 to 14, further comprising:
applying a pass voltage (Vpass) to an unselected word line during the forcing dump period, the bit line forcing period, and the forcing sustain period; and
applying a program voltage (Vpgm) to a selected word line during the forcing dump period, the bit line forcing period, and the forcing sustain period.
